# EUROPEAN PATENT SPECIFICATION

(11) **EP 4 158 552 B1**
(45) Date of publication and mention of the grant of the patent: **09.12.2026**
(21) Application number: 21783062.9
(22) Date of filing: 02.03.2021
(51) Int. Cl.: G06N 10/20, G06N 10/40, H03K 19/195

(54) **EXECUTION OF N-QUBIT QUANTUM GATES**
AUSFÜHRUNG VON N-QUBIT-QUANTENGATTERN
EXÉCUTION DE PORTES QUANTIQUES DE N BITS QUANTIQUES

(30) Priority: 29.05.2020 US 202016888351
(43) Date of publication of application: 05.04.2023
(60) Divisional application: 23175295.7 / 4 235 520
(73) Proprietor: Microsoft Technology Licensing, LLC, Redmond, WA 98052-6399 (US)
(72) Inventor: KLIUCHNIKOV, Vadym, Redmond, Washington 98052-6399 (US); VASCHILLO, Alexander, Redmond, Washington 98052-6399 (US); ROETTELER, Martin Henri, Redmond, Washington 98052-6399 (US)
(74) Representative: Page White Farrer
(86) International application number: PCT/US2021/020485
(87) International publication number: WO 2021/252035

(56) References cited:
- DANIEL LITINSKI: "A Game of Surface Codes: Large-Scale Quantum Computing with Lattice Surgery", ARXIV.ORG, CORNELL UNIVERSITY LIBRARY, 201 OLIN LIBRARY CORNELL UNIVERSITY ITHACA, NY 14853, 8 August 2018 (2018-08-08), XP081255132
- CUOMO DANIELE ET AL: "Towards a Distributed Quantum Computing Ecosystem (Invited Paper)", 28 March 2020 (2020-03-28), pages 1 - 8, XP055860542, Retrieved from the Internet <URL:https://arxiv.org/pdf/2002.11808v2.pdf> [retrieved on 20211111]
- SARVAGHAD-MOGHADDAM MOEIN ET AL: "A General protocol for Distributed Quantum Gates", 21 December 2018 (2018-12-21), pages 1 - 8, XP055860554, Retrieved from the Internet <URL:https://arxiv.org/ftp/arxiv/papers/1812/1812.07798.pdf> [retrieved on 20211111]

## Description

### BACKGROUND

A quantum computer is a physical machine configured to execute logical operations based on or influenced by quantum-mechanical phenomena. Whereas conventional computer memory holds digital data in an array of bits and enacts bit-wise logical operations, a quantum computer holds data in an array of qubits and operates quantum-mechanically on the qubits in order to implement the desired logic. One or more quantum-logic gates may thus be applied to operate on a set of qubits. In "A Game of Surface Codes: Large-Scale Quantum Computing with Lattice Surgery", Litinski discloses that full quantum computations can be performed in surface-code-based architectures of different sizes using computational schemes that do not require any prior knowledge about the input circuit.

### SUMMARY

The invention is defined by the independent claims. Embodiments of the inventions are defined in the dependent claims.

### BRIEF DESCRIPTION OF THE DRAWINGS

FIG. 1 shows aspects of an example quantum computer.
FIG. 2 illustrates a Bloch sphere, which graphically represents the quantum state of one qubit of a quantum computer.
FIG. 3 illustrates example qubit planes.
FIG. 4 is an example method for remote execution of a quantum gate on a quantum computing device.
FIG. 5 is an example method for delayed execution of a quantum gate on a quantum computing device.
FIG. 6A schematically shows an example quantum circuit for the delayed remote execution of a CCZ gate.
FIG. 6B schematically shows an example quantum circuit for executing an n-qubit gate.
FIG. 7 schematically shows an example quantum circuit identity.
FIG. 8 schematically shows the example quantum circuit of FIG. 6 following application of the identity circuit of FIG 7.
FIG. 9 schematically shows the example quantum circuit of FIG. 8, following commuting assertion gates past the CCZ gates.
FIG. 10 schematically shows an example quantum circuit identity.
FIG. 11 schematically shows the example quantum circuit of FIG. 9 following application of the identity circuit of FIG 10.
FIG. 12 schematically shows an example quantum circuit for decomposing a CCZ gate as a product of Pauli exponents.
FIG. 13 schematically shows the example quantum circuit of FIG. 11 with a decomposed CCZ gate as shown in FIG. 12.
FIG. 14 schematically shows an example quantum circuit identity.
FIG. 15 schematically shows the example quantum circuit of FIG. 13 following application of the identity circuit of FIG 14.
FIG. 16 schematically shows additional quantum circuit identities.

### DETAILED DESCRIPTION

Quantum computing uses quantum mechanical properties to enable computations for specific applications that would otherwise not be feasible to perform in a reasonable amount of time on conventional (i.e., nonquantum), state-of-the-art computers. Example applications include prime factorization, database searches, and physics and chemistry simulations. The fundamental unit of computation on a quantum computer is a qubit. A quantum gate or quantum logic gate is a quantum circuit configured to operate on a number of qubits. Quantum gates may serve as analogues to classical logic gates in conventional digital computers.

Direct execution of certain quantum gates may require a set of qubits positioned in adjacent locations on a quantum computing device. Additionally, execution of these gates may require that special states such as T-states be delivered to and applied to the qubits in question. Complex algorithms may be required to resolve the geometric issues of delivering qubits to proper locations. This makes the execution of such gates both expensive and location dependent.

Further, execution of subsequent gates on any qubit in the set of qubits may be delayed until a previous one is successfully applied. Execution of such gates can be a relatively lengthy process, so executing such a gate directly could cause a delay in the execution of subsequent gates involving these qubits. Direct execution of such a gate could be physically impossible, and indirect gate execution on non-adjacent qubits may exponentially increase computational expenses.

Herein, methods are presented that mitigate both the issues of physical adjacency and delays in execution. Remote execution of an n-qubit gate may be performed by performing local Pauli gates and local joint Pauli measurements on pairs of qubits with pre-established connectivity. With this layout method for a quantum gate, the execution of any diagonal *n*-qubit gate can be delayed and/or can be performed remotely. This method further enables the pipelining of the execution of commuting diagonal gates even if they act on the same qubits, as the offloading of measurements may free up target qubits before error correction stages are completed.

Further, the execution of such diagonal *n*-qubit gates often depends on a supply of qubits in special states. These special qubit states are usually produced by state factories positioned in a static location. Remote execution of such gates may thus be performed on a set of qubits located close to such factories rather than on a set located elsewhere in the quantum plane, thus increasing the speed of operations while reducing error rates.

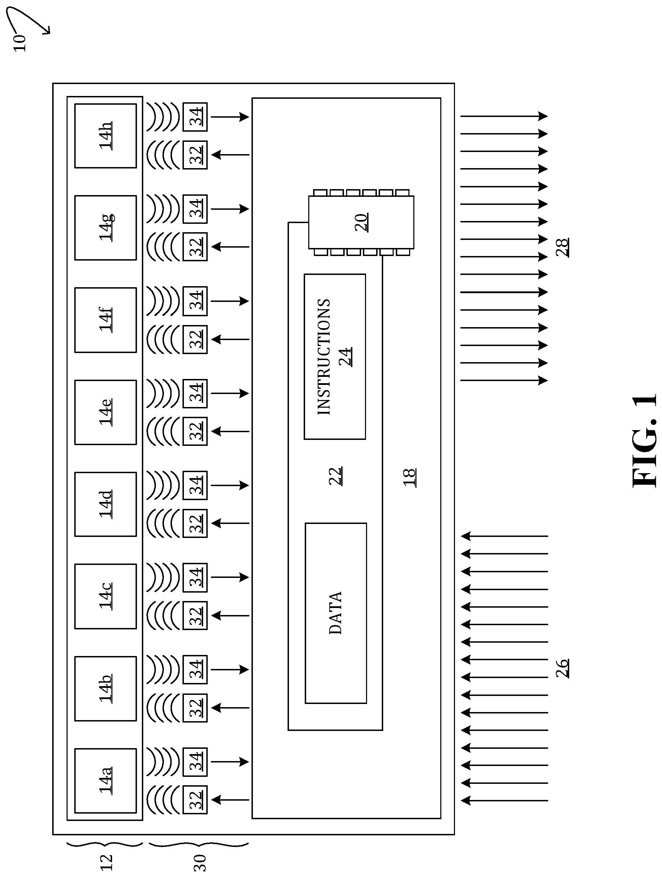

For context, aspects of quantum-computer architecture will first be described. Turning now to the drawings, FIG. 1 shows aspects of an example quantum computer 10 configured to execute quantum-logic operations (*vide infra*). Whereas conventional computer memory holds digital data in an array of bits and enacts bit-wise logic operations, a quantum computer holds data in an array of qubits and operates quantum-mechanically on the qubits in order to implement the desired logic. Accordingly, quantum computer 10 of FIG. 1 includes at least one qubit register 12 comprising an array of qubits 14. The illustrated qubit register is eight qubits in length; qubit registers comprising longer and shorter qubit arrays are also envisaged, as are quantum computers comprising two or more qubit registers of any length.

Qubits 14 of qubit register 12 may take various forms, depending on the desired architecture of quantum computer 10. Each qubit may comprise: an encoding of Majorana quasiparticles and/or other topologically protected quantum systems, a superconducting Josephson junction, a trapped ion, a trapped atom coupled to a high-finesse cavity, an atom or molecule confined within a fullerene, an ion or neutral dopant atom confined within a host lattice, a quantum dot exhibiting discrete spatial- or spin-electronic states, electron holes in semiconductor junctions entrained via an electrostatic trap, a coupled quantum-wire pair, an atomic nucleus addressable by magnetic resonance, a free electron in helium, a molecular magnet, or a metal-like carbon nanosphere, as non-limiting examples. More generally, each qubit 14 may comprise any particle or system of particles that can exist in two or more discrete quantum states that can be measured and manipulated experimentally. For instance, a qubit may be implemented in the plural processing states corresponding to different modes of light propagation through linear optical elements (*e.g*., mirrors, beam splitters and phase shifters), as well as in states accumulated within a Bose-Einstein condensate.

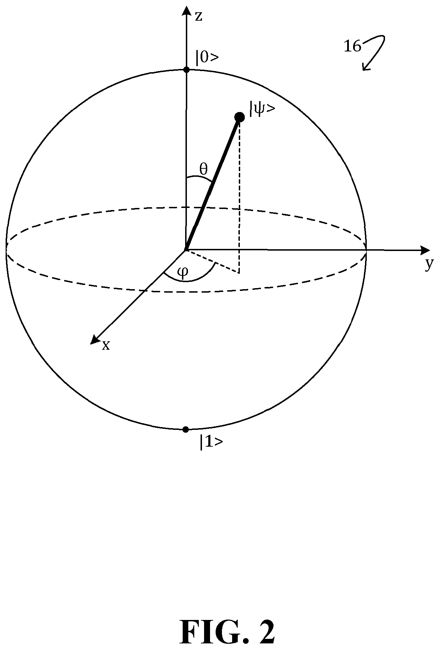

FIG. 2 is an illustration of a Bloch sphere 16, which provides a graphical description of some quantum mechanical aspects of an individual qubit 14. In this description, the north and south poles of the Bloch sphere correspond to the standard basis vectors |0〉 and |1〉, respectively-up and down spin states, for example, of an electron or other fermion. The set of points on the surface of the Bloch sphere comprise all possible pure states |*ψ*〉 of the qubit, while the interior points correspond to all possible mixed states. A mixed state of a given qubit may result from decoherence, which may occur because of undesirable coupling to external degrees of freedom.

Returning now to FIG. 1, quantum computer 10 includes a controller 18. The controller may include at least one processor 20 and associated computer memory 22. A processor 20 of controller 18 may be coupled operatively to peripheral componentry, such as network componentry, to enable the quantum computer to be operated remotely. A processor 20 of controller 18 may take the form of a central processing unit (CPU), a graphics processing unit (GPU), or the like. As such, the controller may comprise classical electronic componentry. The terms 'classical' and 'non-quantum' are applied herein to any component that can be modeled accurately as an ensemble of particles without considering the quantum state of any individual particle. Classical electronic components include integrated, microlithographed transistors, resistors, and capacitors, for example. Computer memory 22 may be configured to hold program instructions 24 that cause processor 20 to execute any function or process of the controller. In examples in which qubit register 12 is a low-temperature or cryogenic device, controller 18 may include control componentry operable at low or cryogenic temperatures-*e.g*., a field-programmable gate array (FPGA) operated at 77K. In such examples, the low-temperature control componentry may be coupled operatively to interface componentry operable at normal temperatures.

Controller 18 of quantum computer 10 is configured to receive a plurality of inputs 26 and to provide a plurality of outputs 28. The inputs and outputs may each comprise digital and/or analog lines. At least some of the inputs and outputs may be data lines through which data is provided to and/or extracted from the quantum computer. Other inputs may comprise control lines via which the operation of the quantum computer may be adjusted or otherwise controlled.

Controller 18 is operatively coupled to qubit register 12 via quantum interface 30. The quantum interface is configured to exchange data bidirectionally with the controller. The quantum interface is further configured to exchange signal corresponding to the data bidirectionally with the qubit register. Depending on the architecture of quantum computer 10, such signal may include electrical, magnetic, and/or optical signal. Via signal conveyed through the quantum interface, the controller may interrogate and otherwise influence the quantum state held in the qubit register, as defined by the collective quantum state of the array of qubits 14. To this end, the quantum interface includes at least one modulator 32 and at least one demodulator 34, each coupled operatively to one or more qubits of the qubit register. Each modulator is configured to output a signal to the qubit register based on modulation data received from the controller. Each demodulator is configured to sense a signal from the qubit register and to output data to the controller based on the signal. The data received from the demodulator may, in some examples, be an estimate of an observable to the measurement of the quantum state held in the qubit register. Taken together, the controller, modulator, and demodulator may be referred to as a 'controller system'.

In some examples, suitably configured signal from modulator 32 may interact physically with one or more qubits 14 of qubit register 12 to trigger measurement of the quantum state held in one or more qubits. Demodulator 34 may then sense a resulting signal released by the one or more qubits pursuant to the measurement, and may furnish the data corresponding to the resulting signal to controller 18. Stated another way, the demodulator may be configured to output, based on the signal received, an estimate of one or more observables reflecting the quantum state of one or more qubits of the qubit register, and to furnish the estimate to the controller. In one non-limiting example, the modulator may provide, based on data from the controller, an appropriate voltage pulse or pulse train to an electrode of one or more qubits, to initiate a measurement. In short order, the demodulator may sense photon emission from the one or more qubits and may assert a corresponding digital voltage level on a quantum-interface line into the controller. Generally speaking, any measurement of a quantum-mechanical state is defined by the operator *O* corresponding to the observable to be measured; the result *R* of the measurement is guaranteed to be one of the allowed eigenvalues of *O*. In quantum computer 10, *R* is statistically related to the qubit-register state prior to the measurement, but is not uniquely determined by the qubit-register state.

Pursuant to appropriate input from controller 18, quantum interface 30 may be configured to implement one or more quantum-logic gates to operate on the quantum state held in qubit register 12. Whereas the function of each type of logic gate of a classical computer system is described according to a corresponding truth table, the function of each type of quantum gate is described by a corresponding operator matrix. For example, an *n-*qubit gate may be represented by a 2*ⁿ* x 2*ⁿ* square matrix with entries that are complex numbers. The operator matrix operates on (*i.e*., multiplies) the complex vector representing the qubit register state and effects a specified rotation of that vector in Hilbert space.

For example, the Hadamard gate *H* is defined by $H = \frac{1}{\sqrt{2}} \left[\begin{matrix}1 & 1 \\ 1 & - 1\end{matrix}\right]$ (1)

The *H* gate acts on a single qubit; it maps the basis state |0〉 to $\left(\left|0\right〉+\left|1\right〉\right) / \sqrt{2}$, and maps |1〉 to $\left(\left|0\right〉-\left|1\right〉\right) / \sqrt{2}$. Accordingly, the *H* gate creates a superposition of states that, when measured, have equal probability of revealing |0〉 or |1〉.

The phase gate *S* is defined by $S = \left[\begin{matrix}1 & 0 \\ 0 & {e}^{iπ / 2}\end{matrix}\right] .$ (2)

The *S* gate leaves the basis state |0〉 unchanged but maps |1〉 to *e*^{*iπ*/2}|1〉*.* Accordingly, the probability of measuring either |0〉 or |1〉 is unchanged by this gate, but the phase of the quantum state of the qubit is shifted. This is equivalent to rotating a wavefunction |*ψ*〉 by 90 degrees along a circle of latitude on the Bloch sphere of FIG. 2.

Some quantum gates operate on two or more qubits. The SWAP gate, for example, acts on two distinct qubits and swaps their values. This gate is defined by $SWAP = \left[\begin{matrix}1 & 0 & 0 & 0 \\ 0 & 0 & 1 & 0 \\ 0 & 1 & 0 & 0 \\ 0 & 0 & 0 & 1\end{matrix}\right] .$ (3)

The foregoing list of quantum gates and associated operator matrices is non-exhaustive, but is provided for ease of illustration. Other quantum gates include *Pauli-X*, *- Y, and* -*Z* gates, the $\sqrt{NOT}$ gate, additional phase-shift gates, the $\sqrt{SWAP}$ gate, controlled *cX*, *cY*, and *cZ* gates, and the Toffoli, Fredkin, Ising, and Deutsch gates, as non-limiting examples. Diagonal gates are considered non-trivial gates that include mostly zeros, excepting for the diagonal elements of the matrix.

Single qubit Pauli matrices include the following 4 matrices: $I = \left(\begin{matrix}1 & 0 \\ 0 & 1\end{matrix}\right) , X = \left(\begin{matrix}0 & 1 \\ 1 & 0\end{matrix}\right) , Y = \left(\begin{matrix}0 & - i \\ i & 0\end{matrix}\right) , Z = \left(\begin{matrix}1 & 0 \\ 0 & - 1\end{matrix}\right)$ (4) whereas *n*-qubit Pauli matrices are matrices of the following form: ${P}_{1} ⊗ {P}_{2} ⊗ … ⊗ {P}_{n} , {P}_{k} ∈ \left\{I, X, Y, Z\right\} , k = 1 , … , n$ (5)

*N*-qubit Pauli matrices may be referred to as simply Pauli matrices. Note that Pauli matrices are Hermitian (self-adjoint). In other words, for all *P* such that *P* is a Pauli matrix it is the case that *P*^{†} = *P*.

Pauli unitaries are matrices of the form *i^{k}P*, where *P* is a Pauli matrix, $i = \sqrt{- 1}$ and *k* is an arbitrary integer. Pauli operators are matrices of the form ±*P*, where *P* is a Pauli matrix. A multiplication table of Pauli matrices is shown in Table 1. Using this table one can compute the product of two arbitrary Pauli unitaries. For example, row *X* and column *Y* contain the product *XY = iZ)*.

**Table 1**

| | *X* | *Y* | *Z* |
|---|---|---|---|
| *X* | *I* | *iZ* | *-iY* |
| *Y* | *-iZ* | *I* | *iX* |
| *Z* | *iY* | *-iX* | *I* |

As an example, let *P* be an *n*-qubit Pauli operator from {*I*, *X, Y, Z*}^{⊗*n*}, then exp(*iϕP*) *= I*^{⊗*n*} cos(*ϕ*) + *is*in(*ϕ*)*P*. This can be proven by first checking that this is true for *P* = Z and *n* = 1; then, applying the fact that for every Pauli *P* there exists a Clifford unitary C such that *P* = *CZ* ⊗ *I*^{⊗(*n-*1)}*C*^{†}, and that
*C*exp(*iϕZ* ⊗ *I*^{⊗(*n*-1)})*C*^{†} = exp(*iϕC*(*Z* ⊗ *I*^{⊗(*n*-1)})*C*^{†}) = *I*^{⊗*n*} cos(*ϕ*) + *i*sin(*ϕ*)*P*. (6)

Alternatively, one can show the same statement using the power series expansions of exp, sin and cos and the fact that the square of every Pauli operator is identity.

Continuing in FIG. 1, suitably configured signal from modulators 32 of quantum interface 30 may interact physically with one or more qubits 14 of qubit register 12 so as to assert any desired quantum-gate operation. As noted above, the desired quantum-gate operations are specifically defined rotations of a complex vector representing the qubit register state. In order to effect a desired rotation *O*, one or more modulators of quantum interface 30 may apply a predetermined signal level *Sᵢ* for a predetermined duration *Tᵢ*. In some examples, plural signal levels may be applied for plural sequenced or otherwise associated durations, to assert a quantum-gate operation on one or more qubits of the qubit register. In general, each signal level *Sᵢ* and each duration *Tᵢ* is a control parameter adjustable by appropriate programming of controller 18.

The terms 'oracle' and 'quantum program' are used herein to describe a predetermined sequence of elementary quantum-gate and/or measurement operations executable by quantum computer 10. An oracle may be used to transform the quantum state of qubit register 12 to effect a classical or non-elementary quantum-gate operation or to apply a density operator, for example. In some examples, an oracle may be used to enact a predefined 'black-box' operation *f*(*x*), which may be incorporated in a complex sequence of operations. To ensure adjoint operation, an oracle mapping *n* input qubits |*x*〉 to *m* output or ancilla qubits |*y*〉 *= f*(*x*) may be defined as a quantum gate *O*(|*x*〉 ⊗ |*y*〉) operating on the *n + m* qubits. In this case, *O* may be configured to pass the *n* input qubits unchanged but combine the result of the operation *f*(*x*) with the ancillary qubits via an XOR operation, such that *O*(|*x*〉 ⊗ |*y*〉) = |*x*〉 ⊗ |*y + f*(*x*)〉*.* A state-preparation oracle is an oracle configured to generate a quantum state of specified qubit length.

Implicit in the description herein is that each qubit 14 of qubit register 12 may be interrogated via quantum interface 30 so as to reveal with confidence the standard basis vector |0〉 or |1〉 that characterizes the quantum state of that qubit. In some implementations, however, measurement of the quantum state of a physical qubit may be subject to error. Accordingly, any qubit 14 may be implemented as a logical qubit, which includes a grouping of physical qubits measured according to an error-correcting oracle that reveals the quantum state of the logical qubit with confidence.

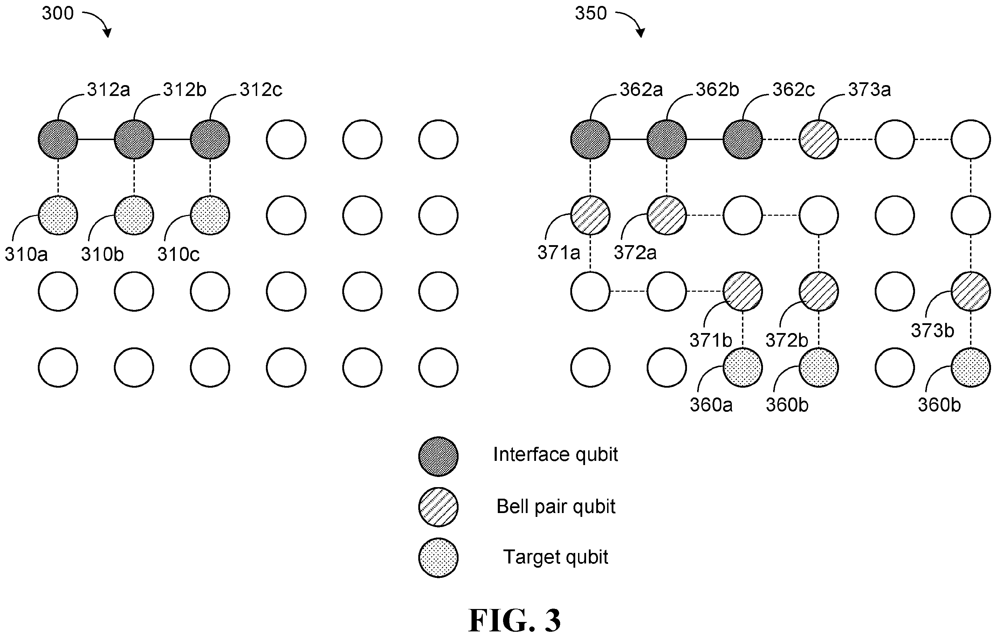

FIG. 3 shows an example qubit plane 300 where a plurality of qubits are arranged in a grid. In this example a diagonal n-qubit gate is requested where n=3. A set of 3 qubits 310a, 310b, and 310c are identified as target qubits, each physically adjacent to an interface qubit (312a, 312b, and 312c). Joint Z-Z measurements are performed on each pair of qubits (e.g., 310a and 312a, shown connected by a dashed line). The gate may then be performed on the interface qubits based on the Z-Z measurements, followed by performing Pauli corrections.

However, it is possible to execute such diagonal gates on pairs of target/interface qubits even if the qubit pairs are not physically adjacent to each other. Z-Z measurements may be performed on qubits that are located in different parts of the qubit plane provided they share some degree of connectivity. Qubit plane 350 shows example target qubits 360a, 360b, and 360c connected to interface qubits 362a, 362b, and 362c, connected together with dashed lines representing a defined connectivity path. Herein, qubits that share connectivity but are not physically adjacent to each other are referred to as being "remotely" located to each other.

Generally, these connectivity paths may be prepared ahead of time if they share a special state between the pairs. In this example, Bell pairs 371a and 371b, 372a and 372b, and 373a and 373b are presented on qubit plane 350 such that each pair of target and interface qubits share a Bell pair. For example, target qubit 360a and interface qubit 362a share Bell pair 371a and 371b.

For pairs of qubits that share a Bell pair, the joint Z-Z measurement may be performed simply by consuming the Bell pair. This allows for remote gate execution similar to teleportation operations. For additional measurements, the qubits may begin in a "pre-shared" state, where for any 2 qubits, one link is pre-shared ahead of time in order to prepare the circuit to perform remote joint Z-Z measurements.

Once the Z gates are applied, the Z measurements may be recorded, and Pauli corrections applied. However, for some operations, such as swap gates, diagonal gates, Clifford gates, etc., these corrections do not need to be executed immediately. Rather, the corrections may be moved past the gates. As such, the gate execution may be initiated, but there is no need for the target qubit corrections to be completed prior to freeing the target qubits for additional use. As diagonal gates take additional time to execute, this normally would prevent all involved qubits from being reused until the gate is finalized. By moving the correction (e.g., delaying correction) the target qubits may be applied by new gates without waiting for corrections to be finalized. This allows for pipelining of quantum operations.

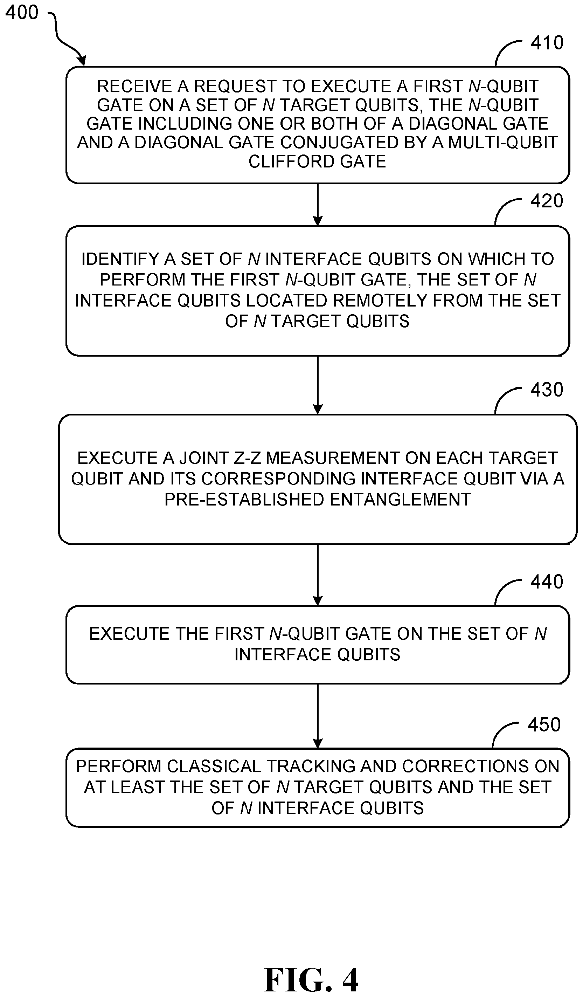

FIG. 4 is an example method 400 for operating a quantum computing device. Method 400 may be enacted to enable the remote execution of n-qubit gates within a quantum plane of the quantum computing device.

At 410, method 400 includes receiving a request to execute a first *n*-qubit gate on a set of *n* target qubits, the *n*-qubit gate including one or both of a diagonal gate and a diagonal gate conjugated by a multi-qubit Clifford gate. The request may be received at a controller of the quantum computing device, and the set of *n* target qubits may be defined by the controller. The request may specify particular qubits with appropriate states, properties, characteristics, relative locations, etc. A set of *n* target qubits that meets these properties may be identified by the controller and used to satisfy the request. *N* may be an integral number of qubits such that *n* ≥ 1. Although described predominantly with regard to multi-qubit gates, the systems and methods described herein are applicable to single-qubit gates.

Generally, if gate *D* is an *n*-qubit diagonal gate, and Clifford gate *C* is an *m-*qubit gate, where *m* ≥ *n* qubits, then the extended method can also execute *C* (*D* ⊗ *I*) *C*^{*-*1}, where *I* is an (*m-n*) qubit identity gate. In some examples, the first *n*-qubit gate may be a diagonal *n*-qubit quantum gate, such as a CCZ gate.

Other common diagonal gates include, but are not limited to the *R*_{z} gate given by the diagonal matrix {{exp(-iφ/2),0}, {0,exp(iφ/2)} (1 qubit gates); *R*_{z} gates with n control qubits (*n*+1 qubit gates); *Z* gates with *n* control qubits (*n*+1 qubit gates); *R*₁ gates given by the diagonal matrix {{1,0}, {0,exp(iφ/2)} (1 qubit gates); *R*₁ gates with *n* control qubits (*n*+1 qubit gate); and any *S* and/or *T* gates with or without controls. The first n-qubit gate may be executed as part of an algorithm that includes one or more additional gates.

Continuing at 420, method 400 includes identifying a set of *n* interface qubits on which to perform the first *n*-qubit gate, the set of *n* interface qubits including one or more qubits located remotely from the set of *n* target qubits. As described with regard to FIG. 3, one or more of the interface qubits may not be located adjacent to the target qubits, and may not inherently have connectivity to the target qubits. Rather, one or more of the interface qubits may be located elsewhere on the quantum plane in a place where it is convenient to perform the requested *n*-qubit gate, e.g., near a source of magic-states, such as T-states. The interface qubits may comprise some, all, or equivalent properties for performing the requested gate that were used to select the target qubits. The interface qubits may be prioritized for assignment for gates that are costly or timely to complete, whereas gates that are relatively easy to execute locally may not be executed remotely, such as H, S, X, Y and Z gates.

At 430, method 400 includes executing a joint Z-Z measurement on each target qubit and its corresponding interface qubit via a pre-established entanglement. In some examples, a multi-qubit Pauli measurement is made in addition to or as an alternative to the joint Z-Z measurement. This may allow for the method to be applied to a wider class of gates, and may allow for the number of interface qubits to be greater than or equal to the number of target qubits.

As one example, the method may include establishing a set of *n* Bell pairs, such that a first qubit of each Bell pair is positioned locally to a first qubit of the *n* target qubits, and a second qubit of the Bell pair is located remotely at a first qubit of the *n* interface qubits. In this way, the quantum computing device is effectively executing joint Z-Z measurement between target and interface qubits via the Bell-pair.

For example, the first qubit of each Bell pair may be positioned adjacent to or otherwise with connectivity to a target qubit, and the second qubit of the Bell pair may be positioned adjacent to or otherwise with connectivity to an interface qubit, thereby establishing connectivity between a target qubit and a corresponding non-adjacently located interface qubit. The Bell pairs may be established based on the inputs to the gate, a description of the underlying qubit plane fabric (qubit connectivity), and properties of the requested gate. In some examples, the acts of identifying target qubits, identifying interface qubits, and establishing Bell pairs may be performed in any order, in parallel, or otherwise independent of each other. For example, Bell pairs can be prepared well in advance, allowing for parallelization of executing the method. At 440, method 400 includes executing the first *n*-qubit gate on the set of *n* interface qubits.

At 450, method 400 includes performing classical tracking and corrections on at least the set of *n* target qubits and the set of *n* interface qubits. As an example, method 400 may include identifying, via classical tracking, one or more qubits within the set of *n* target qubits to which Z correction is indicated. Responsive to completing the execution of the first *n*-qubit gate on the set of *n* interface qubits, spin is measured along X on the set of *n* interface qubits. Measured spin values for X may be stored, and then one or more qubits within the set of *n* interface qubits to which Z correction is indicated may be identified. Z correction may then be performed on at least the identified target qubits and the identified interface qubits. In some examples, multi-qubit Pauli corrections may be performed in addition to or as an alternative to Z corrections. In some examples, Z correction may also be performed on any related qubits based on the classical results previously obtained and/or on collected tracking data. For example, if, while the first *n*-qubit gate was executing, the user's algorithm was simultaneously performing operations involving the identified target qubit and any other data qubits, then Z correction may be applied to those related data qubits. Once Z corrections are delayed, they can be spread to other qubits. A set of such related qubits may be tracked classically.

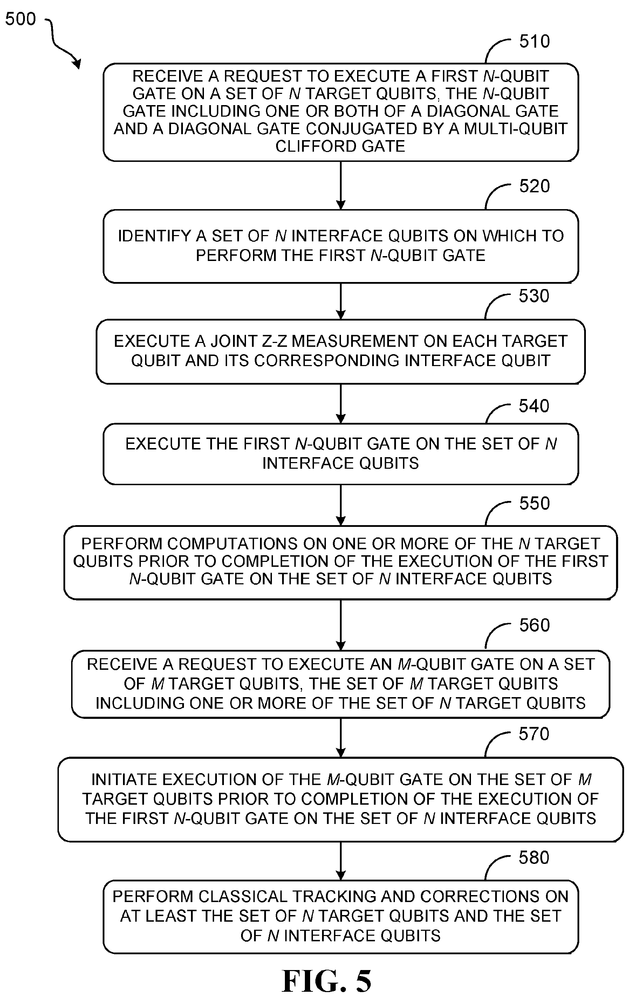

FIG. 5 is an example method 500 for operating a quantum computing device. Method 500 may be enacted to enable the delayed execution of *n*-qubit gates within a quantum plane of the quantum computing device. Method 500 may be performed in conjunction with, as an extension of, or independently of method 400.

At 510, method 500 includes receiving a request to execute a first n-qubit gate on a set of *n* target qubits, the n-qubit gate including one or both of a diagonal gate and a diagonal gate conjugated by a multi-qubit Clifford gate. The request may be received at a controller of the quantum computing device, and the set of *n* target qubits may be defined by the controller. As described with regard to method 400, *n* is an integral number of qubits such that *n* ≥ 1. Continuing at 520, method 500 includes identifying a set of *n* interface qubits on which to perform the first *n*-qubit gate. In this example, each interface qubit may be located either local to or remotely from its corresponding target qubit.

At 530, method 500 includes executing a joint Z-Z measurement on each target qubit and its corresponding interface qubit. Such measurements may be performed by any suitable means, such as, but not limited to, the methods described with regard to 430 of FIG. 4. In some examples, a multi-qubit Pauli measurement is made in addition to or as an alternative to the joint Z-Z measurement. At 540, method 500 includes executing the first n-qubit gate on the set of *n* interface qubits.

At 550, method 500 includes performing computations on one or more of the *n* target qubits prior to completion of the execution of the first *n*-qubit gate on the set of *n* interface qubits. This allows for parallel execution of gates which are assigned to the same set of target qubits. Performing computations on one or more of the *n* target qubits may occur in response to execution of the joint Z-Z measurement on each target qubit and its corresponding interface qubit, and/or associated Bell pair, as described with regard to FIG. 4.

At 560, method 500 includes receiving a request to execute a second *n*-qubit gate on the set of *n* target qubits. In other words, the second n-qubit gate can be executed without waiting for Pauli corrections on target qubits. Gates that can be initiated prior to completion of the execution of the diagonal gates on the interface qubits include, but are not limited to any combination of SWAP, Pauli, parity measurements and diagonal gates; and any combination of Clifford, SWAP, multi-qubit Pauli measurements and Pauli gates (SWAP and Pauli gates are special case of Clifford gates). Gates that are locally executed, such as Clifford and SWAP gates may be executed on the set of *n* target qubits.

As such, at 570, method 500 includes, initiating execution of the second *n-*qubit gate on the set of *n* target qubits prior to completion of the execution of the first *n-*qubit gate on the set of *n* interface qubits. In examples where one or more interface qubits are also target qubits, such a qubit may not be reused until execution of the first *n*-qubit gate is completed. If, according to the presiding algorithm, such a qubit is not needed initially for the second *n*-qubit gate, execution of the second *n*-qubit gate may still be initiated prior to completion of execution of the first *n*-qubit gate.

At 580, method 500 includes performing classical tracking and corrections on at least the set of *n* target qubits and the set of *n* interface qubits, as described with regard to 450 of FIG. 4. Such tracking may be performed while computation on the target qubits is ongoing as described at 550.

The methods described with regards to FIGS. 4 and 5 may be further generalized for broader applicability. As an example, a method for a quantum computer includes receiving a request to execute an *n*-qubit gate on a set of *n* target qubits, where *n* is an integer and *n* ≥ 1, and where the *n*-qubit gate is an *m*-qubit diagonal gate conjugated by an *n*-qubit Clifford gate, where *m* is an integer and *m* ≤ *n*. The Clifford gate may be any single-qubit or multiple-qubit Clifford gate, including an identity gate. The quantum computing device identifies a set of *m* interface qubits on which to perform the *m-*qubit diagonal gate. The *m* interface qubits may be located locally to their corresponding target qubits, remotely, or any combination thereof.

Such a method may then include executing a Clifford operation on each interface qubit and its corresponding target qubits. The Clifford operation may include a single or multi-qubit Clifford unitary, and/or a single or multi-qubit Pauli measurement. Such a multi- qubit Pauli measurement can be executed via pre-established entanglement as described herein, via Bell pairs, or by any other means. The *m*-qubit diagonal gate is then executed on the set of *m* interface qubits. In some examples, the Clifford operations include multi-qubit Pauli gates X-controlled on the interface qubits. An X-controlled multi-qubit Pauli gate may take the form of a Clifford unitary described by the matrix ((*I + X*)/2)⊗*I +* ((*I -X*)/2)⊗*P*, where *P* is an arbitrary multi-qubit Pauli operation.

Computations may be performed on one or more of the *n* target qubits prior to completion of the execution of the first *m*-qubit diagonal gate on the set of *m* interface qubits. The quantum computing device may receive a request to execute an *n*'-qubit gate on a set of *n'* target qubits, the set of *n'* target qubits including one or more of the set of *n* target qubits. *N*" may be equal to *n,* or may be a larger or smaller integer. Execution of the *n*'-qubit gate may be initiated on the set of *n*' target qubits prior to completion of the execution of the first *m*-qubit diagonal gate on the set of *m* interface qubits. One or more qubits may be identified within the set of *n* target and *n'* target qubits to which multi-qubit Pauli correction is indicated.

Responsive to completing the execution of the *m*-qubit diagonal gate on the set of *m* interface qubits, spin is measured along *X* on the set of *m* interface qubits.
Measured spin values for *X* may be stored, and multi-qubit Pauli corrections may be performed on at least the identified target qubits.

Using the methods described herein, the execution of any diagonal *n*-qubit gate can be delayed, performed remotely, or both. Remote execution can be performed by consuming *n* Bell states and performing local Pauli gates and local joint Pauli measurements. As an example, this approach can be demonstrated using the case of delayed remote execution of a CCZ gate, which is performed by consuming three Bell pairs. One skilled in the art will recognize that the following proof for the CCZ gate is applicable to the general case of any *n*-qubit diagonal gate or *m*-qubit diagonal gate conjugated by an *n-*qubit Clifford gate, where *m* is an integer and *m* ≤ *n*.with modest changes for the selected gate.

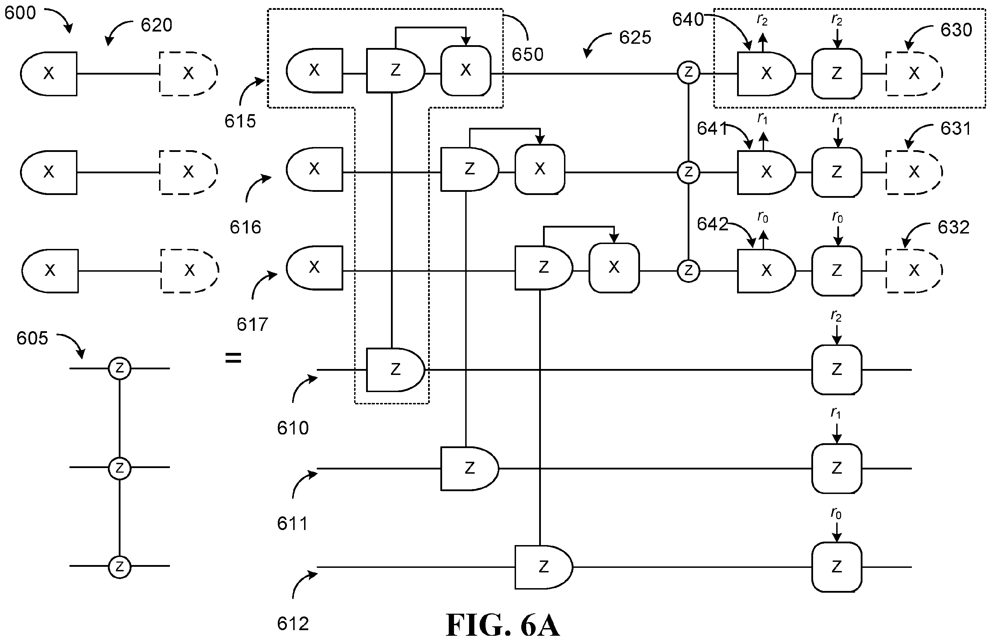

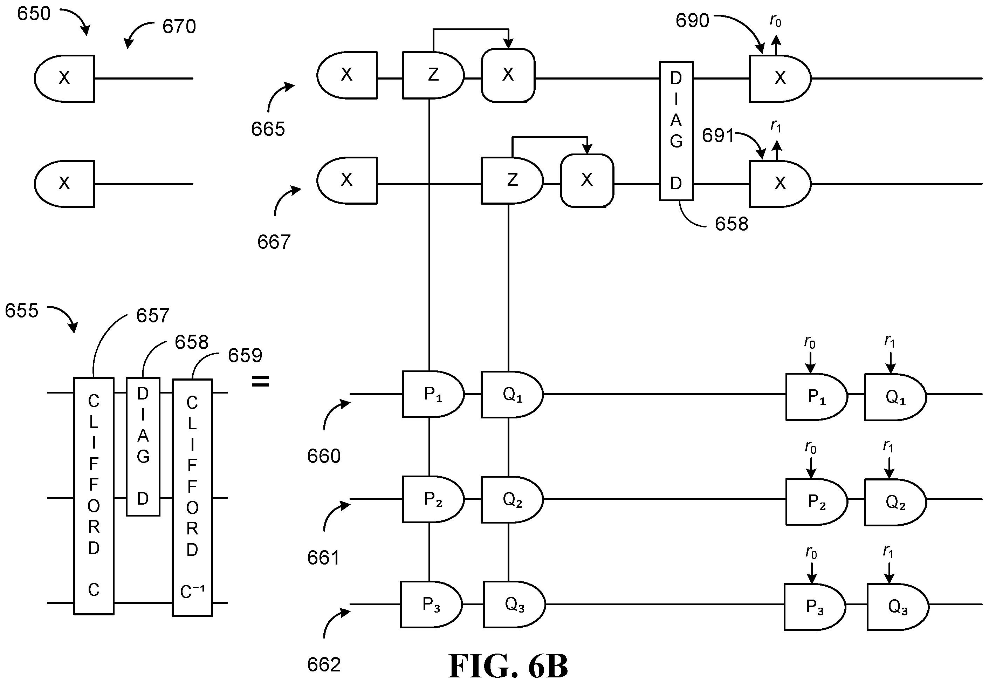

FIG. 6A shows an example circuit 600 for the delayed remote execution of a CCZ gate 605 on three target qubits (610, 611, 612) via three interface qubits (615, 616, 617). Left hand side 620 represents a classical CCZ gate, whereas right hand side 625 represents a delayed, remotely execute CCZ gate. Gates labeled "X" and surrounded by dashed lines (630, 631, 632) positioned on the right hand side of circuit 600 indicate that the state of each of three target qubits (610, 611, 612) is +1 eigenstate of X. Arrows extending from qubits labeled X and surrounded by solid lines (640, 641, 642) directing into a register (*r*₀*, r*₁*, r*₂) indicates that the measurement outcome for the respective qubit is written to the indicated register. Arrows directed into a Pauli X or Pauli Z gate show that the gate is executed if a corresponding measurement outcome or recorded register value is +1. As shown here, the circuit on the right side of FIG. 6 (625) executes a CCZ gate as summarized by the following proposition:
**Proposition 1.1:** Circuits 620 and 625, as illustrated in FIG. 6 are equivalent. The circuit on the right-hand side (circuit 625) executes a CCZ gate (605) on three interface qubits (615, 616, 617) and returns the target qubits (610, 611, 612) back to +1 eigenstate of Pauli X.

A more generalized circuit 650 is shown in FIG. 6B. Circuit 650 may be employed for delayed and/or remote execution of a series of gates 655, including a three-qubit Clifford gate (C) 657, a two-qubit diagonal gate (D) 658, and a three-qubit inverse Clifford gate (C⁻¹) 659. Circuit 650 enables execution of the conjugated diagonal gate 655 on three target qubits (660, 661, 662) via two interface qubits (665, 667). The diagonal gate 655 may be executed on the two interface qubits 665 and 667. As shown at 690 and 691, the measurement outcome for the respective qubit is written to the indicated register (r₀, r₁). As per FIG. 6A, arrows directed into a Pauli X or Pauli Z gate show that the gate is executed if a corresponding measurement outcome or recorded register value is +1. P₁, P₂, & P₃, and Q₁, Q₂, & Q₃ are determined by Clifford gate 657and can be any one of the set of {Identity, X, Y, Z}.

As described with regard to FIG. 3, the target qubits (610, 611, 612)) and interface (615, 616, 617) qubits in circuit 600 of FIG. 6 can be located in different parts of a quantum computer. To execute a CCZ gate on the interface qubits (616, 617, 618) it is sufficient to perform pair-wise joint *Z* ⊗ *Z* measurements. Each such measurement can be performed by consuming a Bell pair, hence remote execution. Moreover, the computation on the interface qubits (616, 617, 618) can continue before the values of measurement outcomes stored in *r*₀*, r*₁*, r*₂ are known. For example, if the CCZ gate is followed by a Clifford gate, then the Pauli corrections are transformed into some other Pauli correction by the Clifford gate. Hence, the execution of the gate is delayed. This method for delayed remote execution also allows for the pipelining of the execution of commuting diagonal gates even if they act on the same qubits.

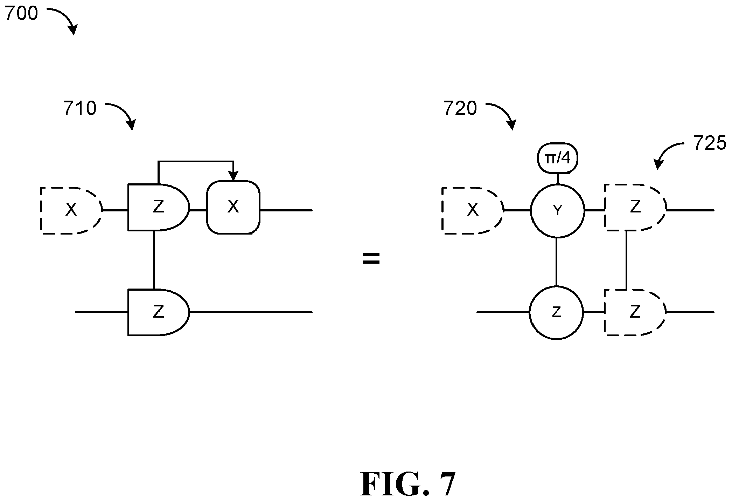

This result may be shown by using a series of circuit transformations, illustrated in FIGS. 7-16. The proof comprises three main stages. First, all the measurements in the circuit are replaced with ±π/4 exponents of Pauli operators exp ( $\pm i \frac{π}{4} Y ⊗ Z$). This is possible due to additional information known about Pauli operators that stabilize the state during computation. Second, the CCZ gate is decomposed as a product of seven Pauli exponents, showing that the overall circuit applies the product of seven different Pauli exponents to all six qubits. This follows from the fact that the conjugation of a general exponent of a Pauli operator by π/4 exponents of Pauli operators is equal to another exponent of a Pauli operator. Finally, it may be demonstrated that these new exponents of Pauli operators act on all six qubits in the same fashion as seven exponents of Pauli operators acting solely on the bottom three qubits. The action of the different exponents is equivalent because the top three qubits are initialized to +1 eigenstate of *X.* This is due to the fact that different Pauli exponents can act on the state in the same way, if the state is +1 eigenstate of a Pauli operator. The seven exponents acting on the bottom three qubits are equal to the decomposition of the CCZ gate into the exponents of Pauli operators.

Returning to FIG. 6, a portion 650 of circuit 600 is indicated with dashed lines. FIG. 7 shows a circuit identity 700 that may be applied to portion 650. Circuit identity 700 illustrates the equivalence of a *Z* ⊗ *Z* measurement 710 and a Pauli exponent exp ( $i \frac{π}{4} Y ⊗ Z$) 720. The connected pair of Zs (725) shown in dashed lines on the very right of the circuit 720 demonstrate that the final state is +1 eigenstate of *Z* ⊗ *Z* . Such gates may be referred to as assertion gates.

**Proposition 1.2:** Let |*ψ*〉 be an *n*-qubit state and let Pauli operator *Q* stabilize |*ψ*〉, that is *Q*|*ψ*〉 = |*ψ*〉. Consider *n*-qubit Pauli operator *P* that anti-commutes with *Q*. Then, the measurement of *P* with correction *Q* upon -1 outcome is equivalent to applying unitary $I + PQ \sqrt{2}$. The probability of the measurement outcome is 1/2 and the resulting state is stabilized by *P*.

To prove this, first it is determined whether measuring *P* gives either outcome +1 or -1 with a probability of 1/2. Indeed, the probability of measuring +1 is $\frac{\left〈ψ\right| I + P \left|ψ\right〉}{2} = \frac{\left〈ψ\right| I - P \left|ψ\right〉}{2}$ and it is equal to: $\frac{\left〈ψ\right| Q \left(I+P\right) Q \left|ψ\right〉}{2} = \frac{\left〈ψ\right| I + QPQ \left|ψ\right〉}{2} = \frac{\left〈ψ\right| I - P \left|ψ\right〉}{2}$ (7)

Thus, the probability of measuring +1 and -1 is the same and their sum is one. Therefore, the probability of each measurement outcome is 1/2. This means that in the case of a +1 outcome the state becomes $\left(I+P\right) \left|ψ\right〉 / \sqrt{2}$ which is equal to $\left(I+PQ\right) \left|ψ\right〉 / \sqrt{2}$, which is a Clifford unitary. Similarly, in case of a -1 outcome, $\left(I-PQ\right) \left|ψ\right〉 / \sqrt{2}$ can be applied. After applying correction *Q* upon outcome -1, the state becomes $Q \left(I-PQ\right) \left|ψ\right〉 / \sqrt{2} = \left(I+PQ\right) \left|ψ\right〉 / \sqrt{2}$ . The correction forces the result back to +1 measurement outcome and therefore the result is stabilized by *P*.

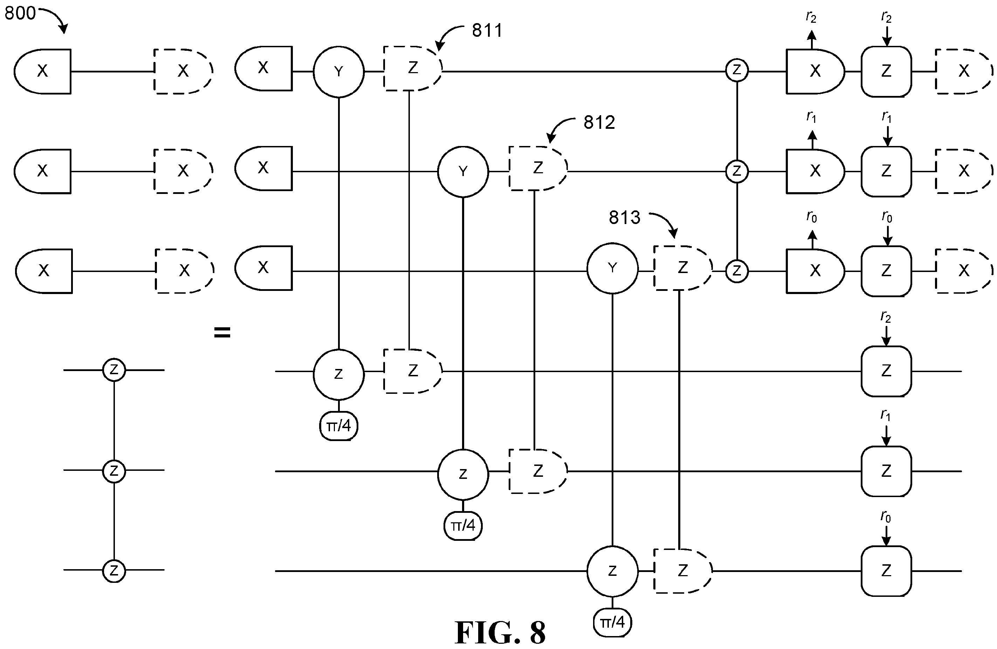

Because *P* and *Q* in the proposition above anti-commute, there exist *P'* from {*I,X,Y,Z*}^{⊗*n*} such that *PQ* = ±*iP'* and therefore $\frac{I + PQ}{\sqrt{2}} = exp \left(\pm i\frac{π}{4}P′\right)$. Applying the circuit identity 700 from FIG. 7 to circuit 625 from FIG. 6 allows for the replacement of the first three *Z* ⊗ *Z* measurements with π/4 Pauli exponents and leads to the example quantum circuit 800 shown in FIG. 8, resulting in a circuit with three *Z* ⊗ *Z* assertion gates (811, 812, 813).

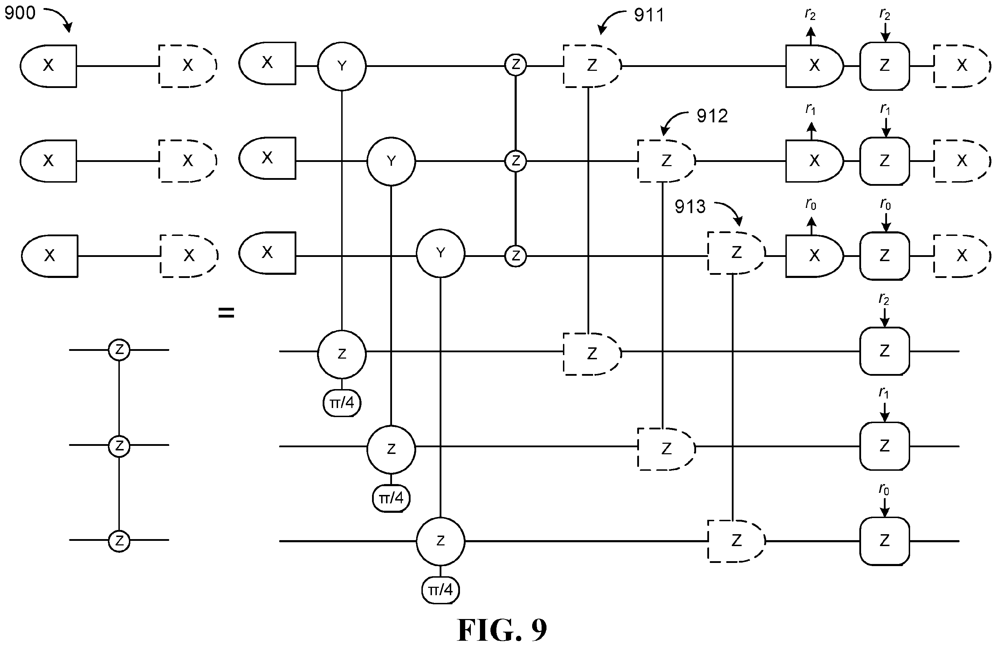

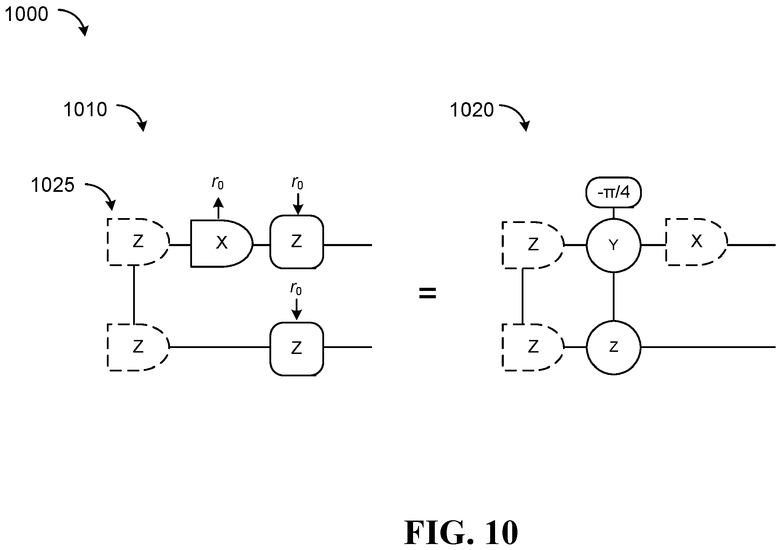

The *Z* ⊗ *Z* assertion gates (811, 812, 813) in circuit 800 can be commuted past a CCZ gate, and similarly past any diagonal gate. This leads to the circuit diagram 900 shown in FIG. 9 including three assertion gates (911, 912, 913). FIG. 10 shows another quantum circuit identity 1000, demonstrating the equivalence of measurement (1010) and Pauli exponents (1020). The connected pair of Zs (1025) on the very left of the diagram indicates that the initial state is stabilized by *Z* ⊗ *Z*.

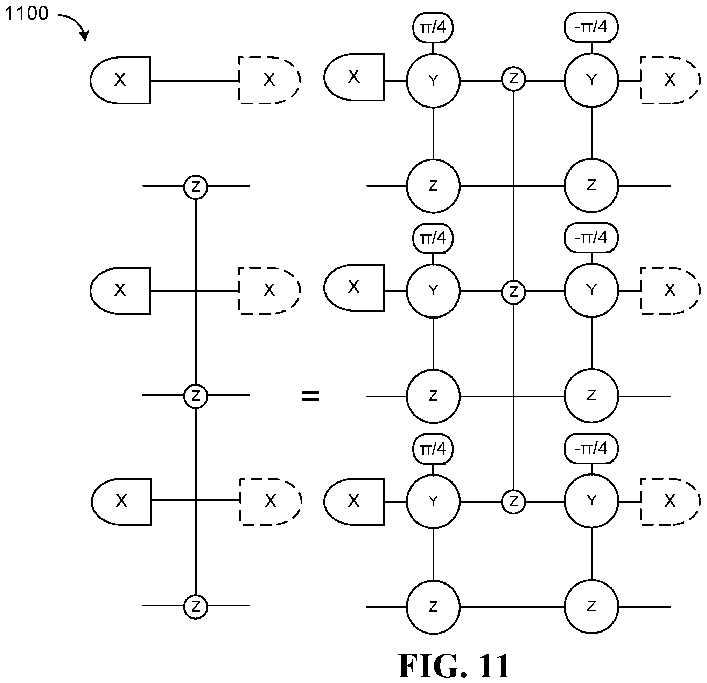

This circuit identity 1000 may be applied to the assertion gates 911, 912, and 913 as shown in FIG. 9 as well as to the other similar sub-circuits. This replaces the remaining *X* measurements with -π/4 Pauli exponents. The circuit identity shown in FIG. 10 is similar to the one shown in FIG. 7, following from Proposition 1.2. The result of *X* measurement replacement is shown in FIG. 11, with circuit 1100 indicating the result of applying the identity of FIG. 10 to FIG. 9 and reordering qubits.

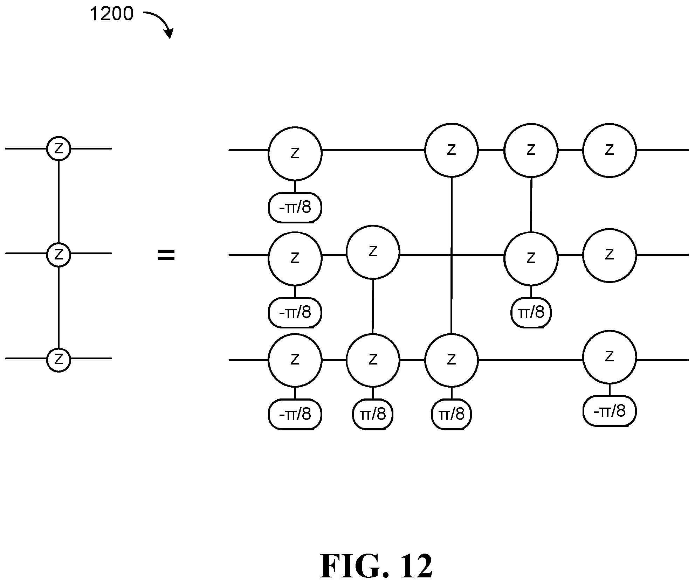

The next step is to represent the CCZ gate as a product of seven exponents of Pauli operators, as described in the below proposition 1.3 and illustrated by circuit 1200 in FIG. 12, which shows the decomposition of the CCZ gate as a product of Pauli exponents.

**Proposition 1.3:** Twice controlled-Z gate CCZ can be represented as: ${\prod }_{P ∈ \left〈-{Z}_{1},-{Z}_{2},-{Z}_{3}\right〉} exp \left(i\frac{π}{8}P\right)$ (8) where 〈-*Z*₁, *-Z*₂*,* -*Z*₃〉 is the Abelian group generated by -*Z*₁ = *-Z* ⊗ *I* ⊗ *I*, -*Z*₂ = *-I* ⊗ *Z* ⊗ *I, -Z*₃ *= -I* ⊗ *I* ⊗ *Z* .

To prove this, the CCZ gate may be written as exp(*iπ*|111〉〈111|), then using the fact that |1〉〈1| = (1 - Z)/2 it can be seen that: $exp \left(iπ\left|111\right〉\left〈111\right|\right) = exp \left(i\frac{π}{8}\left(I-Z\right)⊗\left(I-Z\right)⊗\left(I-Z\right)\right) .$ (9)

Here, (*I - Z*) ⊗ (*I - Z*) ⊗ (*I - Z*) = Σ_{*P*∈〈*-Z*1*,-Z*2,*-Z*3〉}*P*. Using the fact that for commuting matrices *A* and *B* exp(A + B) = exp(A) exp(B) completes the proof. It may also be noted that any n-qubit diagonal gate can be written as ${\prod }_{P ∈ \left〈{Z}_{1},{Z}_{2},…,{Z}_{n}\right〉} exp \left({iϕ}_{P}P\right)$ (10) for appropriate choice of phases *ϕ_{P}*. It is useful to keep this in mind to see how this proof for CCZ gates generalizes to arbitrary *n*-qubit gates.

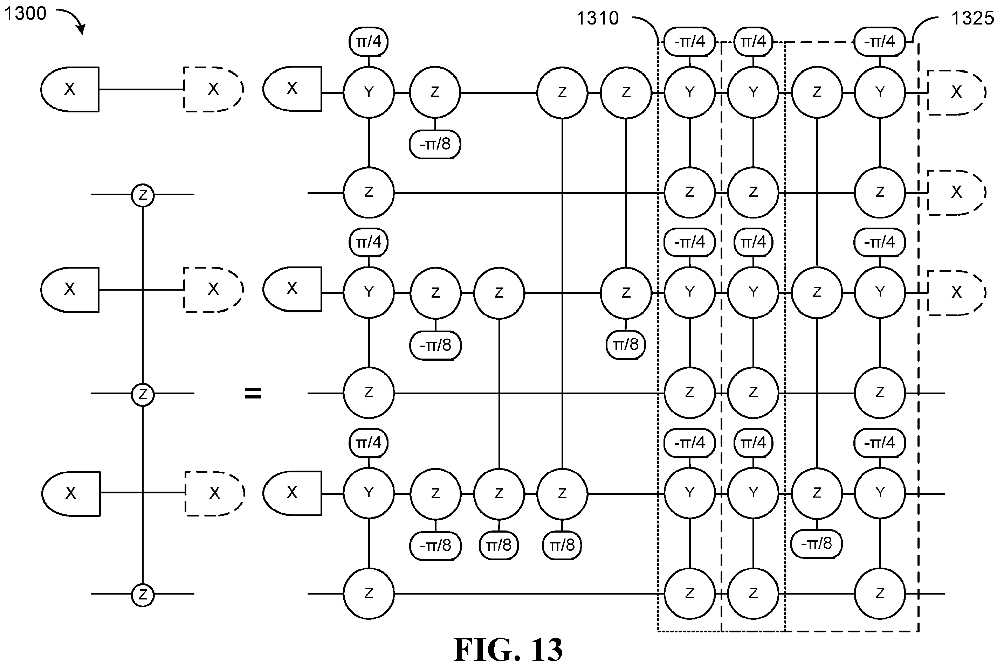

Using the decomposition for CCZ gate leads to the quantum circuit 1300 shown in FIG. 13, where the quantum circuit 1100 is converted by replacing the CCZ gate with its decomposition in terms of exponents of Pauli operators. Further, circuit 1300 includes inserted Pauli exponent gates that cancel each other, as shown at 1310.

**Proposition 1.4:** Let *P* and *Q* be n-qubit Pauli operators. Then $exp \left(i\frac{π}{4}P\right) Q exp \left(-i\frac{π}{4}P\right)$ is equal to *Q* if *P* and *Q* commute, and is equal to *iPQ* otherwise. Similarly, $exp \left(i\frac{π}{4}P\right) exp \left(iϕQ\right) exp \left(-i\frac{π}{4}P\right)$ is equal to exp(*iϕQ*) if *P* and *Q* commute, and is equal to exp (*iϕ*(*iPQ*)) otherwise.

As proof, if *P* and *Q* commute, then $exp \left(i\frac{π}{4}P\right)$ and *Q* also commute. This implies that $exp \left(i\frac{π}{4}P\right) Q exp \left(-i\frac{π}{4}P\right) = exp \left(i\frac{π}{4}P\right) exp \left(-i\frac{π}{4}P\right) Q = Q$ (11).

If *P* and Q do not commute, they must anti-commute, therefore $exp \left(i\frac{π}{4}P\right) Q exp \left(-i\frac{π}{4}P\right) = \frac{I + iP}{\sqrt{2}} Q \frac{I - iP}{\sqrt{2}} = \frac{{\left(I+iP\right)}^{2} Q}{2} = \frac{2 iPQ}{2} = iPQ$ (12) because for any matrices *A, B A* exp(*B*)*A*⁻¹ *=* exp(*ABA*⁻¹), part of the result for exp(*iϕQ*) is established.

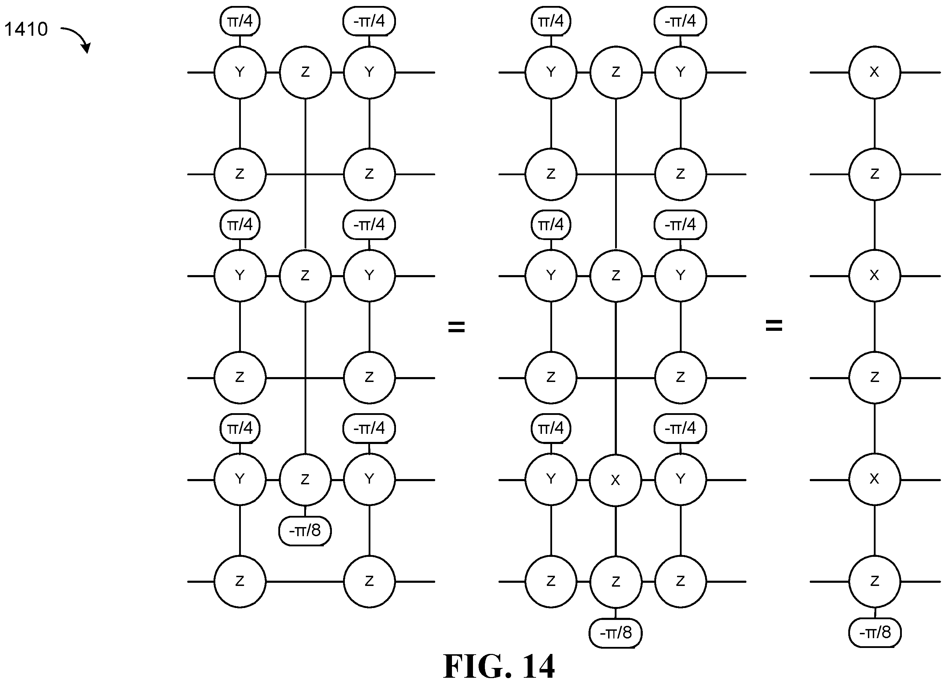

FIG. 14 schematically shows an example identity circuit 1400 that follows from Proposition 1.4, showing how conjugation by π/4 Pauli exponents transforms other Pauli exponents. This identity may be applied to the outlined portion 1325 of circuit 1300 by inserting the Pauli exponent gates.

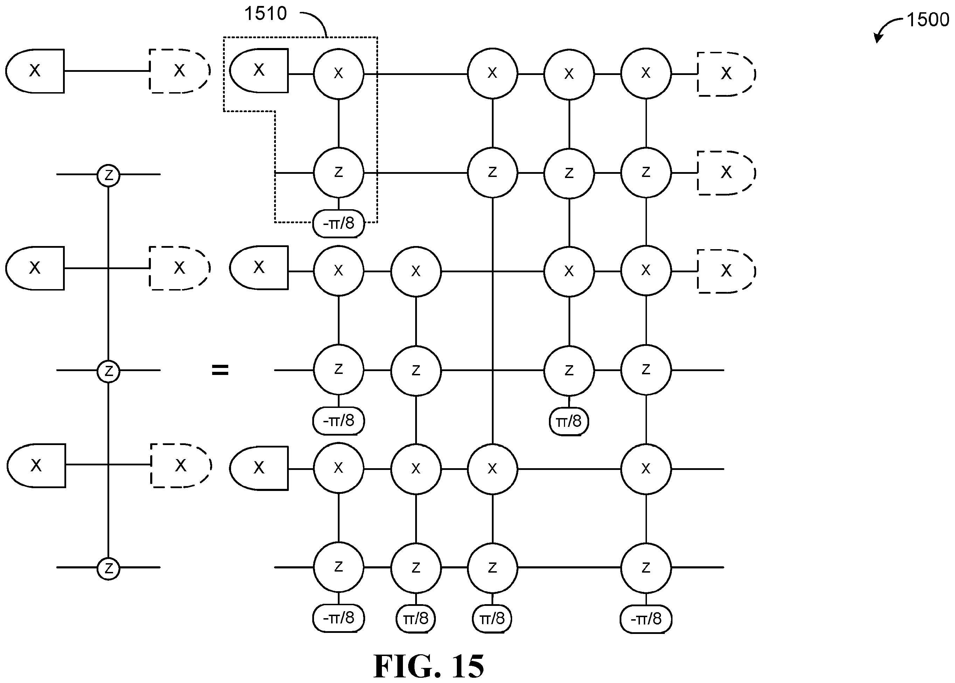

Repeatedly applying Proposition 1.4 and identity from circuit 1400 to circuit 1300 allows for the transformation of all ±π/8 Pauli exponents and removal of all ±π/4 Pauli exponents, resulting in the example quantum circuit 1500 shown in FIG. 15.

**Proposition 1.5:** Let |*ψ*〉 be an n-qubit state and let Pauli operator *Q* stabilize |*ψ*〉, that is let *Q*|*ψ*〉 = |*ψ*〉. For any operator *P* commuting with *Q*, exp (***i**ϕ**P***)|*ψ*〉 = exp (*iϕQP*)|*ψ*〉*.*

As proof, recall that exp(***i**ϕ**P***) = *I*^{⊗*n*} cos(*ϕ*) + *i*sin(*ϕ*)*P*. Thus if *Q*|ψ〉 = |*ψ*〉 , it is implied that $\left({I}^{⊗ n}cos\left(ϕ\right)+isin\left(ϕ\right)P\right) \left|ψ\right〉 = \left({I}^{⊗ n} cos\left(ϕ\right)+isin\left(ϕ\right)PQ\right) \left|ψ\right〉$ (13). Because *P* and *Q* commute, the product *PQ* is a Hermitian operator and *I*^{⊗*n*} cos(*ϕ*) + *i*sin(*ϕ*)*PQ* = exp (*iϕQP*)*.*

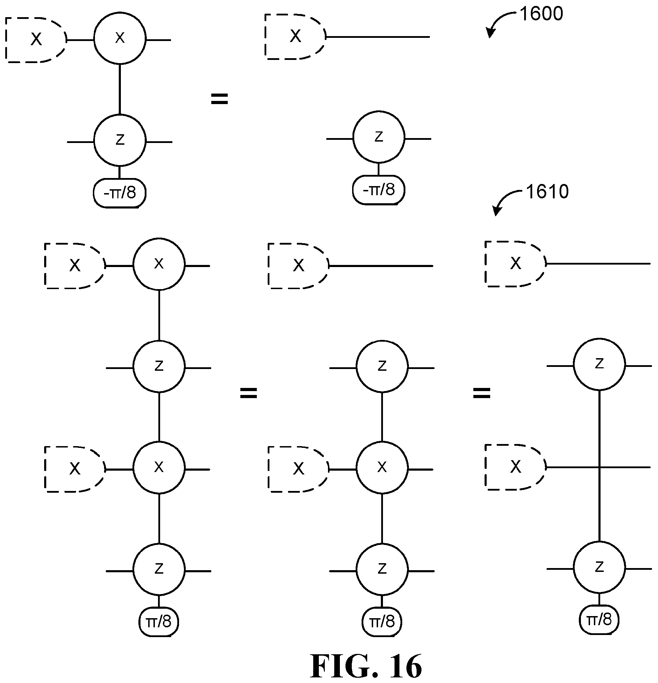

This proposition allows for further simplification of outlined portion 1510 of FIG. 15 by removing the *X* term from the exponent. The proposition leads to circuit identities 1600 and 1610 shown in FIG. 16. Repeatedly applying Proposition 1.5 to circuit 1500 removes all *X*'s from Pauli exponents, and the equivalence of left-hand and right-hand side circuits follows from the decomposition of CCZ in terms of seven Pauli exponents as shown in FIG 12.

Despite the capabilities of quantum computers, they are still limited in throughput over time. The methods disclosed herein enable advanced construction within such a resource constrained quantum computer. Remote and delayed execution methods allow for the implementation of a rich class of algorithms, as they eliminate requirements to break down each operator and then rely on standard methods for implementing the operators over a static layout. In other words, the above provides a direct way of remotely performing diagonal *n*-qubit gates among other gates.

Diagonal *n*-qubit gates can take a relatively long time to execute. The methods described herein enact a time savings in executing quantum algorithms by enabling parallelized execution. Diagonal *n*-qubit gates can be performed in parallel while the quantum computer is performing other operations. The quantum computer may effectively be separated into two domains: one for performing diagonal *n*-qubit gates and one for performing all other gates. This speeds up execution of quantum algorithms, returning solutions faster.

A primary goal of quantum computing is to solve commercially valuable problems. Presently, this is achieved by using quantum error correction protocols and fault tolerant protocols. Currently there exists one primary fault tolerant protocol (lattice surgery surface code). This protocol is enacted with a certain set of basic operations. The methodology described herein may be implemented as an add-on to those basic operations. This methodology is valuable to both large-scale quantum computers as well as to smaller (e.g., 100 qubit) computers where there is a desire to improve resource utilization.

As one example, a method for operating a quantum computing device, comprises receiving a request to execute a first n-qubit gate on a set of n target qubits, the n-qubit gate including one or both of a diagonal gate and a diagonal gate conjugated by a multi-qubit Clifford gate; identifying a set of n interface qubits on which to perform the first n-qubit gate, the set of n interface qubits located remotely from the set of n target qubits; executing a joint Z-Z measurement on each target qubit and its corresponding interface qubit via a pre-established entanglement; and executing the first n-qubit gate on the set of n interface qubits. In such an example, or any other example, each remotely located interface qubit is additionally or alternatively located non-adjacently to a corresponding target qubit. In any of the preceding examples, or any other example, the pre-established entanglement additionally or alternatively includes a set of n Bell pairs, such that a first qubit of each Bell pair is positioned locally to a first qubit of the n target qubits, and a second qubit of the Bell pair is positioned locally to a first qubit of the n interface qubits. In any of the preceding examples, or any other example, the method additionally or alternatively comprises identifying, via classical tracking, one or more qubits within the set of n target qubits for which Z correction is indicated. In any of the preceding examples, or any other example, the method additionally or alternatively comprises, responsive to completing the execution of the first n-qubit gate on the set of n interface qubits, measuring spin along X on the set of n interface qubits; storing measured spin values for X; and identifying, via classical tracking, one or more qubits within the set of n interface qubits for which Z correction is indicated. In any of the preceding examples, or any other example, the method additionally or alternatively comprises performing Z correction on at least the identified target qubits and the identified interface qubits. In any of the preceding examples, or any other example, the first n-qubit gate is additionally or alternatively a diagonal n-qubit quantum gate. In any of the preceding examples, or any other example, the first n-qubit gate is additionally or alternatively executed as part of a set of 2 or more gates.

In another example, a method for operating a quantum computing device comprises receiving a request to execute a first n-qubit gate on a set of n target qubits, the n-qubit gate including one or both of a diagonal gate and a diagonal gate conjugated by a multi-qubit Clifford gate; identifying a set of n interface qubits on which to perform the first n-qubit gate; executing a joint Z-Z measurement on each target qubit and its corresponding interface qubit; executing the first n-qubit gate on the set of n interface qubits; and performing computations on one or more of the n target qubits prior to completion of the execution of the first n-qubit gate on the set of n interface qubits. In such an example, or any other example, the method additionally or alternatively comprises receiving a request to execute an m -qubit gate on a set of m target qubits, the set of m target qubits including one or more of the set of n target qubits; and initiating execution of the m-qubit gate on the set of m target qubits prior to completion of the execution of the first n-qubit gate on the set of n interface qubits. In any of the preceding examples, or any other example, the method additionally or alternatively comprises identifying, via classical tracking, one or more qubits within the set of n target qubits for which Z correction is indicated. In any of the preceding examples, or any other example, the method additionally or alternatively comprises, responsive to completing the execution of the first n-qubit gate on the set of n interface qubits, measuring spin along X on the set of n interface qubits; storing measured spin values for X; and identifying, via classical tracking, one or more qubits within the set of n interface qubits to which Z correction is indicated. In any of the preceding examples, or any other example, the method additionally or alternatively comprises performing Z correction on at least the identified target qubits and the identified interface qubits. In any of the preceding examples, or any other example, the first n-qubit gate is additionally or alternatively a diagonal n-qubit quantum gate. In any of the preceding examples, or any other example, the first n-qubit gate is additionally or alternatively executed as part of a set of 2 or more gates. In any of the preceding examples, or any other example, one or more qubits of the set of n interface qubits are additionally or alternatively located remotely from the set of n target qubits.

In yet another example, a method for a quantum computer, comprises receiving a request to execute an *n*-qubit gate on a set of *n* target qubits, where *n* is an integer and *n* ≥ 1, and where the *n*-qubit gate being an *m*-qubit diagonal gate conjugated by an *n-*qubit Clifford gate, where *m* is an integer and *m* ≤ *n*; identifying a set of *m* interface qubits on which to perform the *m*-qubit diagonal gate; executing a multi-qubit Pauli measurement on each interface qubit and its corresponding target qubits; executing the *m*-qubit diagonal gate on the set of *m* interface qubits; performing computations on one or more of the *n* target qubits prior to completion of the execution of the first *m*-qubit diagonal gate on the set of *m* interface qubits; receiving a request to execute an *n*'-qubit gate on a set of *n'* target qubits, the set of *n'* target qubits including one or more of the set of *n* target qubits; initiating execution of the *n*'-qubit gate on the set of *n'* target qubits prior to completion of the execution of the first *m*-qubit diagonal gate on the set of *m* interface qubits; identifying one or more qubits within the set of *n* target and *n'* target qubits to which multi-qubit Pauli correction is indicated; responsive to completing the execution of the *m*-qubit diagonal gate on the set of *m* interface qubits, measuring spin along *X* on the set of *m* interface qubits; storing measured spin values for *X*; and performing multi-qubit Pauli corrections on at least the identified target qubits. In such an example, or any other example, one or more of the set of *m* interface qubits are additionally or alternatively located remotely from corresponding target qubits. In any of the preceding examples, or any other example, the multi-qubit Pauli measurement is additionally or alternatively executed via pre-established entanglement between an interface qubit and corresponding target qubits. In any of the preceding examples, or any other example, the Clifford gate is additionally or alternatively an identity gate.

In still another example, a method for operating a quantum computing device comprises receiving a request to execute a first *n*-qubit gate on a set of *n* target qubits, the first *n*-qubit gate representable as an m-qubit diagonal gate conjugated by a Clifford gate; identifying a set of *m* interface qubits on which to perform the *m-*qubit diagonal gate; executing a Clifford operation on each interface qubit and its corresponding target qubits; and executing the *m*-qubit diagonal gate on the set of *m* interface qubits. In such an example, or any other example, the Clifford operations executed on the interface qubits and corresponding target qubits are additionally or alternatively multi-qubit Pauli measurements. In any of the preceding examples, or any other example, the multi-qubit Pauli measurements are additionally or alternatively executed by using pre-established entanglement. In any of the preceding examples, or any other example, the Clifford operations executed on the interface qubits and corresponding target qubits are additionally or alternatively multi-qubit Pauli gates X-controlled on the interface qubits. In any of the preceding examples, or any other example, the multi-qubit Pauli gates X-controlled on the interface qubits are additionally or alternatively executed using pre-established entanglement.

In a further example, a method for operating a quantum computing device comprises receiving a request to execute a first *n*-qubit gate on a set of *n* target qubits, the first *n*-qubit gate representable as an *m*-qubit diagonal gate conjugated by a Clifford gate where *m* ≤ *n*; identifying a set of *m* interface qubits on which to perform the *m*-qubit diagonal gate; executing a Clifford operation on each interface qubit and its corresponding target qubits; executing the *m*-qubit diagonal gate on the set of *m* interface qubits; and performing computations on one or more of the *n* target qubits prior to completion of the execution of the *m*-qubit diagonal gate on the set of *m* interface qubits. In such an example, or any other example, the Clifford operations executed on interface qubits and corresponding target qubits are additionally or alternatively multi-qubit Pauli measurements. In any of the preceding examples, or any other example, the multi-qubit Pauli measurements are additionally or alternatively executed by using pre-established entanglement. In any of the preceding examples, or any other example, the Clifford operations executed on interface qubits and corresponding target qubits are additionally or alternatively multi-qubit Pauli gates X-controlled on the interface qubits. In any of the preceding examples, or any other example, the multi-qubit Pauli gates X-controlled on the interface qubits are additionally or alternatively executed using pre-established entanglement. In any of the preceding examples, or any other example, the method additionally or alternatively comprises receiving a request to execute an *n'*-qubit gate on a set of *n'* target qubits, the set of *n'* target qubits including one or more of the set of *n* target qubits; and initiating execution of the *n'-*qubit gate on the set of *n'* target qubits prior to completion of the execution of the *m*-qubit diagonal gate on the set of *m* interface qubits. In any of the preceding examples, or any other example wherein *n*'-qubit gates are executed on the set of *n*' target qubits prior to completion of the execution of the *m*-qubit diagonal gate on the set of *m* interface qubits, the Clifford operations executed on interface qubits and corresponding target qubits are additionally or alternatively multi-qubit Pauli measurements. In any of the preceding examples, or any other example, the multi-qubit Pauli measurements are additionally or alternatively executed by using pre-established entanglement. In any of the preceding examples, or any other example, the Clifford operations executed on interface qubits and corresponding target qubits are additionally or alternatively multi-qubit Pauli gates X-controlled on the interface qubits. In any of the preceding examples, or any other example, the multi-qubit Pauli gates X-controlled on the interface qubits are additionally or alternatively executed using pre-established entanglement. In any of the preceding examples, or any other example, the method additionally or alternatively comprises identifying one or more qubits within the set of *n* target qubits and *n'* target qubits to which multi-qubit Pauli correction is indicated; responsive to completing the execution of the *m*-qubit diagonal gate on the set of *m* interface qubits, measuring spin along X on the set of *m* interface qubits; and storing measured spin values for X. In any of the preceding examples, or any other example, the method additionally or alternatively comprises performing multi-qubit Pauli corrections on at least the identified target qubits. In any of the preceding examples, or any other example where multi-qubit Pauli corrections are performed on at least the identified target qubits, the Clifford operations executed on interface qubits and corresponding target qubits are additionally or alternatively multi-qubit Pauli measurements. In any of the preceding examples, or any other example, the multi-qubit Pauli measurements are additionally or alternatively executed by using pre-established entanglement. In any of the preceding examples, or any other example, the Clifford operations executed on interface qubits and corresponding target qubits are additionally or alternatively multi-qubit Pauli gates X-controlled on the interface qubits. In any of the preceding examples, or any other example, the multi-qubit Pauli gates X-controlled on the interface qubits are additionally or alternatively executed using pre-established entanglement.

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

## Claims

1. A method for operating a quantum computing device (10), comprising performing by a controller (18) of the quantum computer device (10) the following steps:
receiving a request to execute a circuit on a set of *n* target qubits (610, 611, 612), where *n* is an integer and *n* ≥ 1, the circuit being:
an *m*-qubit diagonal gate with *n=m*, or
an *m*-qubit diagonal gate conjugated by an *n*-qubit Clifford gate, where *m* is an integer and *m* ≤ *n*;
identifying a set of *m* interface qubits (615, 616, 617) on which to perform the *m*-qubit diagonal gate;
executing a multi-qubit Pauli measurement on each interface qubit and at least one of the *n* target qubits (610, 611, 612);
after executing the multi-qubit Pauli measurements, executing the *m*-qubit diagonal gate on the set of *m* interface qubits (615, 616, 617);
identifying, via measurement of spin along *X* on the *m* interface qubits after executing the *m-*qubit diagonal gate, one or more Pauli corrections to be performed on one or more target qubits within the set of *n* target qubits (610, 611, 612);
performing computations on the one or more target qubits; and
performing the one or more Pauli corrections on the one or more target qubits, wherein the computations are performed on the one or more target qubits after the multi-qubit Pauli measurement on each interface qubit and at least one target qubit but prior to performing the Pauli corrections on the one or more target qubits.

2. The method of claim 1, the steps further comprising:
receiving a request to execute an *n'* -qubit gate on a set of *n'* target qubits, the set of *n'* target qubits including one or more of the set of *n* target qubits (610, 611, 612); and
initiating execution of the *n'*-qubit gate on the set of *n'* target qubits prior to completion of the execution of the circuit on the set of *n* interface qubits.

3. The method of claim 1, wherein the circuit is an *n*-qubit diagonal gate, wherein the multi-qubit Pauli measurement is a joint Z-Z measurement between each target qubit (610, 611, 612) and a corresponding interface qubit (615, 616, 617).

4. The method of claim 1, the steps further comprising:
identifying, based on the measured spin values of the interface qubits along X, one or more qubits within the set of *m* interface qubits (615, 616, 617) to which Z correction is indicated.

5. The method of claim 4, the steps further comprising:
performing Z correction on at least the identified target qubits and the identified interface qubits.

6. The method of claim 1, wherein the circuit is a diagonal n-qubit quantum gate.

7. The method of claim 1, wherein the circuit is executed as part of a set of 2 or more gates.

8. The method of claim 1, wherein each remotely located interface qubit is located non-adjacently to the at least one target qubit.

9. The method of claim 8, wherein the pre-established entanglement includes a set of *n* Bell pairs, such that a first qubit of each Bell pair is positioned locally to a first qubit of the *n* target qubits (610, 611, 612), and a second qubit of the Bell pair is positioned locally to a first qubit of the *n* interface qubits (615, 616, 617).

10. The method of claim 3, wherein the n-qubit diagonal gate is a CCZ gate.

11. The method of claim 1, wherein the circuit is an *m*-qubit diagonal gate conjugated by a n-qubit Clifford gate, where *n* ≥ 1 and *m* ≤ *n*, and wherein each multi-qubit measurement is determined based on the Clifford gate, wherein the Clifford gate is not an identity gate.

12. The method of claim 1, the steps further comprising:
responsive to completing the execution of the *m*-qubit gate on the set of *m* interface qubits (615, 616, 617), measuring a spin value along X of each interface qubit;
storing the measured spin values along X of the *m* interface qubits (615, 616, 617);
identifying the one or more Pauli corrections based on the measured spin values along X of the *m* interface qubits (615, 616, 617).

13. The method of any preceding claim, wherein the computations on the one or more target qubits comprise executing second n-qubit gate on the *n* target qubits (610, 611, 612).

14. A quantum computer (10), comprising:
a qubit register (12) including a plurality of qubits, wherein the plurality of qubits comprises target qubits and interface qubits;
a controller (18) configured to carry out the method of any preceding claim.

## Patentansprüche

1. Verfahren zum Betreiben einer Quantencomputervorrichtung (10), umfassend das Durchführen der folgenden Schritte durch eine Steuereinheit (18) der Quantencomputervorrichtung (10):
Empfangen einer Anforderung zum Ausführen einer Schaltung auf einem Satz von *n* Ziel-Qubits (610, 611, 612), wobei *n* eine ganze Zahl ist und *n* ≥ 1, wobei die Schaltung Folgendes ist:
ein *m*-Qubit-Diagonal-Gatter mit *n*=*m*, oder
ein *m*-Qubit-Diagonal-Gatter, konjugiert durch ein *n-*Qubit-Clifford-Gatter, wobei *m* eine ganze Zahl ist und *m* ≤ *n*;
Identifizieren eines Satzes von *m* Schnittstellen-Qubits (615, 616, 617), auf dem das *m*-Qubit-Diagonal-Gatter ausgeführt werden soll;
Ausführen einer Multi-Qubit-Pauli-Messung an jedem Schnittstellen-Qubit und mindestens einem der *n* Ziel-Qubits (610, 611, 612);
nach dem Ausführen der Multi-Qubit-Pauli-Messungen, Ausführen des *m*-Qubit-Diagonal-Gatters auf dem Satz von *m* Schnittstellen-Qubits (615, 616, 617);
Identifizieren, über eine Messung des Spins entlang *X* an den *m* Schnittstellen-Qubits nach dem Ausführen des *m-*Qubit-Diagonal-Gatters, einer oder mehrerer Pauli-Korrekturen, die an einem oder mehreren Ziel-Qubits innerhalb des Satzes von *n* Ziel-Qubits (610, 611, 612) durchgeführt werden sollen;
Durchführen von Berechnungen an dem einen oder den mehreren Ziel-Qubits; und
Durchführen der einen oder der mehreren Pauli-Korrekturen an dem einen oder den mehreren Ziel-Qubits, wobei die Berechnungen an dem einen oder den mehreren Ziel-Qubits nach der Multi-Qubit-Pauli-Messung an jedem Schnittstellen-Qubit und mindestens einem Ziel-Qubit, aber vor dem Durchführen der Pauli-Korrekturen an dem einen oder den mehreren Ziel-Qubits durchgeführt werden.

2. Verfahren nach Anspruch 1, die Schritte ferner umfassend:
Empfangen einer Anforderung zum Ausführen eines *n'*-Qubit-Gatter auf einem Satz von *n'* Ziel-Qubits, wobei der Satz von *n'* Ziel-Qubits eines oder mehrere des Satzes von *n* Ziel-Qubits (610, 611, 612) einschließt; und
Initiieren der Ausführung des *n'*-Qubit-Gatters auf dem Satz von *n'* Ziel-Qubits, vor dem Abschluss der Ausführung der Schaltung auf dem Satz von *n* Schnittstellen-Qubits.

3. Verfahren nach Anspruch 1, wobei die Schaltung ein *n*-Qubit-Diagonal-Gatter ist, wobei die Multi-Qubit-Pauli-Messung eine gemeinsame Z-Z-Messung zwischen jedem Ziel-Qubit (610, 611, 612) und einem entsprechenden Schnittstellen-Qubit (615, 616, 617) ist.

4. Verfahren nach Anspruch 1, die Schritte ferner umfassend:
Identifizieren, basierend auf den gemessenen Spin-Werten der Schnittstellen-Qubits entlang X, eines oder mehrerer Qubits innerhalb des Satzes von *m* Schnittstellen-Qubits (615, 616, 617), für die eine Z-Korrektur indiziert ist.

5. Verfahren nach Anspruch 4, die Schritte ferner umfassend:
Durchführen einer Z-Korrektur an mindestens den identifizierten Ziel-Qubits und den identifizierten Schnittstellen-Qubits.

6. Verfahren nach Anspruch 1, wobei die Schaltung ein diagonales *n*-Qubit-Quanten-Gatter ist.

7. Verfahren nach Anspruch 1, wobei die Schaltung als Teil eines Satzes von 2 oder mehr Gattern ausgeführt wird.

8. Verfahren nach Anspruch 1, wobei jedes entfernt angeordnete Schnittstellen-Qubit nicht benachbart zu dem mindestens einen Ziel-Qubit angeordnet ist.

9. Verfahren nach Anspruch 8, wobei die im Voraus hergestellte Verschränkung einen Satz von *n* Bell-Paaren einschließt, sodass ein erstes Qubit jedes Bell-Paares lokal zu einem ersten Qubit der *n* Ziel-Qubits (610, 611, 612) positioniert ist und ein zweites Qubit des Bell-Paares lokal zu einem ersten Qubit der *n* Schnittstellen-Qubits (615, 616, 617) positioniert ist.

10. Verfahren nach Anspruch 3, wobei das n-Qubit-Diagonal-Gatter ein CCZ-Gatter ist.

11. Verfahren nach Anspruch 1, wobei die Schaltung ein *m*-Qubit-Diagonal-Gatter ist, konjugiert durch ein *n-*Qubit-Clifford-Gatter, wobei *n* ≥ 1 und *m* ≤ *n*, und wobei jede Multi-Qubit-Messung basierend auf dem Clifford-Gatter bestimmt wird, wobei das Clifford-Gatter kein Identitätsgatter ist.

12. Verfahren nach Anspruch 1, die Schritte ferner umfassend:
als Reaktion auf das Abschließen der Ausführung des *m-*Qubit-Gatters auf dem Satz von *m* Schnittstellen-Qubits (615, 616, 617), Messen eines Spin-Wertes entlang X jedes Schnittstellen-Qubits;
Speichern der gemessenen Spinwerte entlang X der *m* Schnittstellen-Qubits (615, 616, 617);
Identifizieren der einen oder der mehreren Pauli-Korrekturen basierend auf den gemessenen Spinwerten entlang X der *m* Schnittstellen-Qubits (615, 616, 617).

13. Verfahren nach einem der vorstehenden Ansprüche, wobei die Berechnungen an dem einen oder den mehreren Ziel-Qubits das Ausführen eines zweiten n-Qubit-Gatters auf den *n* Ziel-Qubits (610, 611, 612) umfassen.

14. Quantencomputer (10), umfassend:
ein Qubit-Register (12), das eine Vielzahl von Qubits einschließt, wobei die Vielzahl von Qubits Ziel-Qubits und Schnittstellen-Qubits umfasst;
eine Steuereinheit (18), die konfiguriert ist, um das Verfahren nach einem der vorstehenden Ansprüche auszuführen.

## Revendications

1. Procédé permettant de faire fonctionner un dispositif informatique quantique (10), comprenant la réalisation par un contrôleur (18) du dispositif informatique quantique (10) des étapes suivantes :
la réception d'une requête pour exécuter un circuit sur un ensemble de n qubits cibles (610, 611, 612), où *n* est un entier et *n* ≥ 1, le circuit étant :
une porte diagonale à *m* qubits avec *n*=*m*, ou
une porte diagonale à *m* qubits conjuguée par une porte de Clifford à *n* qubits, où *m* est un entier et *m* ≤ *n* ;
l'identification d'un ensemble de *m* qubits d'interface (615, 616, 617) sur lesquels réaliser la porte diagonale à *m* qubits ;
l'exécution d'une mesure de Pauli à plusieurs qubits sur chaque qubit d'interface et sur au moins l'un parmi les *n* qubits cibles (610, 611, 612) ;
après l'exécution des mesures de Pauli à plusieurs qubits, l'exécution de la porte diagonale à *m* qubits sur l'ensemble des *m* qubits d'interface (615, 616, 617) ;
l'identification, par le biais de la mesure de spin le long de *X* sur les *m* qubits d'interface après l'exécution de la porte diagonale à *m* qubits, d'une ou plusieurs corrections de Pauli à réaliser sur un ou plusieurs qubits cibles au sein de l'ensemble de *n* qubits cibles (610, 611, 612) ;
la réalisation de calculs sur le ou les qubits cibles ;
et
la réalisation de la ou des corrections de Pauli sur ledit ou lesdits qubits cibles, dans lequel les calculs sont réalisés sur le ou les qubits cibles après la mesure de Pauli à plusieurs qubits sur chaque qubit d'interface et au moins un qubit cible mais avant la réalisation des corrections de Pauli sur le ou les qubits cibles.

2. Procédé selon la revendication 1, les étapes comprenant en outre :
la réception d'une requête pour exécuter une porte à *n'* qubits sur un ensemble de *n'* qubits cibles, l'ensemble de *n'* qubits cibles comportant un ou plusieurs parmi l'ensemble de *n* qubits cibles (610, 611, 612) ; et
le lancement de l'exécution de la porte à *n'* qubits sur l'ensemble de *n'* qubits cibles avant la fin de l'exécution du circuit sur l'ensemble de *n* qubits d'interface.

3. Procédé selon la revendication 1, dans lequel le circuit est une porte diagonale à *n* qubits, et dans lequel la mesure de Pauli à plusieurs qubits est une mesure conjointe Z-Z entre chaque qubit cible (610, 611, 612) et un qubit d'interface correspondant (615, 616, 617).

4. Procédé selon la revendication 1, les étapes comprenant en outre :
l'identification, sur la base des valeurs de spin mesurées des qubits d'interface le long de X, d'un ou plusieurs qubits au sein de l'ensemble de *m* qubits d'interface (615, 616, 617) pour lesquels une correction Z est indiquée.

5. Procédé selon la revendication 4, les étapes comprenant en outre :
la réalisation d'une correction Z sur au moins les qubits cibles identifiés et les qubits d'interface identifiés.

6. Procédé selon la revendication 1, dans lequel le circuit est une porte quantique diagonale à *n* qubits.

7. Procédé selon la revendication 1, dans lequel le circuit est exécuté dans le cadre d'un ensemble de 2 portes ou plus.

8. Procédé selon la revendication 1, dans lequel chaque qubit d'interface situé à distance est situé de manière non adjacente à l'au moins un qubit cible.

9. Procédé selon la revendication 8, dans lequel l'intrication préétablie comporte un ensemble de *n* paires de Bell, de telle sorte qu'un premier qubit de chaque paire de Bell soit positionné localement par rapport à un premier qubit parmi les *n* qubits cibles (610, 611, 612), et qu'un second qubit de la paire de Bell soit positionné localement par rapport à un premier qubit parmi les *n* qubits d'interface (615, 616, 617).

10. Procédé selon la revendication 3, dans lequel la porte diagonale à n qubits est une porte CCZ.

11. Procédé selon la revendication 1, dans lequel le circuit est une porte diagonale à *m* qubits conjuguée à une porte de Clifford à *n* qubits, où *n* ≥ 1 et *m* ≤ *n*, et dans lequel chaque mesure à plusieurs qubits est déterminée sur la base de la porte de Clifford, dans lequel la porte de Clifford n'est pas une porte d'identité.

12. Procédé selon la revendication 1, les étapes comprenant en outre :
en réponse à la fin de l'exécution de la porte à *m* qubits sur l'ensemble des *m* qubits d'interface (615, 616, 617), la mesure d'une valeur de spin le long de X de chaque qubit d'interface ;
le stockage des valeurs de spin mesurées le long de X des *m* qubits d'interface (615, 616, 617) ;
l'identification de la ou des corrections de Pauli sur la base des valeurs de spin mesurées le long de X des *m* qubits d'interface (615, 616, 617).

13. Procédé selon l'une quelconque revendication précédente, dans lequel les calculs sur le ou les qubits cibles comprennent l'exécution d'une seconde porte à *n* qubits sur les *n* qubits cibles (610, 611, 612).

14. Ordinateur quantique (10), comprenant :
un registre de qubits (12) comportant une pluralité de qubits, dans lequel la pluralité de qubits comprend des qubits cibles et des qubits d'interface ;
un contrôleur (18) configuré pour mettre en œuvre le procédé selon l'une quelconque revendication précédente.
